(19) Europäisches Patentamt
European Patent Office
Office européen des brevets

(11) Publication number: 0 097 012
B1

(12) # EUROPEAN PATENT SPECIFICATION

(45) Date of publication of patent specification: 08.04.87

(51) Int. Cl.$^4$: **C 08 L 67/06,** C 08 F 265/06, C 08 F 2/48, C 08 J 5/24

(21) Application number: 83303221.2

(22) Date of filing: 03.06.83

(54) **Photocurable resins and their use.**

(30) Priority: **10.06.82 GB 8216863**

(43) Date of publication of application: **28.12.83 Bulletin 83/52**

(45) Publication of the grant of the patent: **08.04.87 Bulletin 87/15**

(84) Designated Contracting States: **AT BE CH DE FR GB IT LI LU NL SE**

(56) References cited:
**EP-A-0 014 293**
**DE-A-2 924 848**
**US-A-3 715 293**

**The file contains technical information submitted after the application was filed and not included in this specification**

(73) Proprietor: **WARWICK INTERNATIONAL LIMITED**
**Wortley Moor Road**
**Leeds LS12 4JE (GB)**

(72) Inventor: **Patel, Rajnikant C.**
**3 Abbotswood Road**
**London SW16 1AJ (GB)**

(74) Representative: **Lawrence, Peter Robin Broughton et al**
**GILL JENNINGS & EVERY 53-64 Chancery Lane**
**London WC2A 1HN (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 097 012 B1

**Description**

This invention relates to photocurable compositions based on polymerisable ethylenically unsaturated materials such as unsaturated polyester resins, and that will cure and polymerise upon irradiation.

A conventional way of curing unsaturated polymerisable materials at room temperature is to bring together the polymerisable material, a catalyst and an accelerator. Various combinations of catalysts and accelerators are known, for instance methylethyl ketone and cobalt naphthenate or benzoyl peroxide and a tertiary aromatic amine. It is possible to obtain good curing and water clear products but since curing starts immediately the catalyst is brought into contact with the accelerator it is necessary to supply the user with separate compositions that are fixed immediately prior to use. This disadvantage can, in theory, be avoided by providing a composition that is storage stable and is photocurable, so that curing can be brought about merely by irradiation. Numerous photocurable resin compositions have been proposed. For instance in US Patent 3351603 Chen proposed that methylmethacrylate could be photocured if it included, for instance, ethyl eosin Y dye and tetramethylene ethylene diamine as a reducing agent, together with polymethylmethacrylate.

More recently various other systems have been proposed for curing of unsaturated polymerisable materials.

In US Patent No. 3558309 Laridon describes how certain oxime esters can be used as photopolymerisation initiators and mentions exposure by ultra-violet and tungsten lamps and day light. In US Patents Nos 3715293 and 3801329 Sandner describes the use of certain acetophenone photosensitisers and mentions various exposure systems including ultra-violet and tungsten filament lamps.

In British Patent Specification No. 1408265 ICI propose that photocuring may be brought about by using particular diketone photosensitisers, such as benzil, in combination with certain amines as reducing agents and mentions that sunlight may be used to induce the curing.

Despite these suggestions in the literature that the known systems could be cured by exposure to visible light in practice satisfactory curing has only been obtained with such systems when exposure is by ultraviolet light. This necessitates the provision of special apparatus and safety precautions.

In European Patent Publication 14293 Scott Bader propose that unsaturated polyester resin compositions can be cured by exposure to visible light if they include a benzoyl oxime carbonate ester of a particular formula, an eosin dye of a particular formula, and certain benzylamine reducing agents. However these and other systems have not proved commercially satisfactory. One problem is that it has proved impossible to make storage stable systems that are curable by convenient light such as sunlight or tungsten filament lamp light. Thus although the system may be polymerisable by exposure to such light it also polymerises on storage in the dark and so has totally inadequate shelf life. Another problem is that inadequate cure tends to occur when the composition is in contact with air. Thus the surface of the cured product may remain tacky even though the remainder of the product may have cured satisfactorily.

Another problem is that the compositions may be coloured significantly, due to the relatively large amounts of dye that are normally present.

The present invention therefore is that, despite suggestions to the contrary in the literature, none of the known systems are both storage stable and capable, merely upon exposure to visible light, of providing a product quality as high as that which is obtainable by conventional cold curing chemical systems, especially when being used as a laminating resin.

We have now surprisingly found that if we use a combination of one particular class of catalysts with certain reducing agents and photoreducible dyes the composition is storage stable and yet is curable upon exposure to visible light to give a very satisfactory degree of cure, and in particular to give a degree of cure that is usually as good as the good cures obtainable using conventional chemical cold curing systems such as methylethyl ketone and cobalt naphthenate.

A photocurable composition according to the invention comprises polymerisable ethylenically unsaturated material and a photosensitive catalyst system for curing the polymerisable material and that comprises

a) acetophenone photosensitiser of formula I

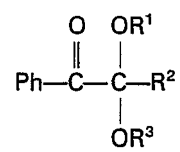

(I)

wherein Ph is an unsubstituted phenyl group, $R^1$ and $R^3$ are each selected from $C_{1-18}$ alkyl groups and $R^2$ is an unsubstituted phenyl group;

b) a dye that is raised to an excited state by exposure to visible light that is an eosin of the formula II

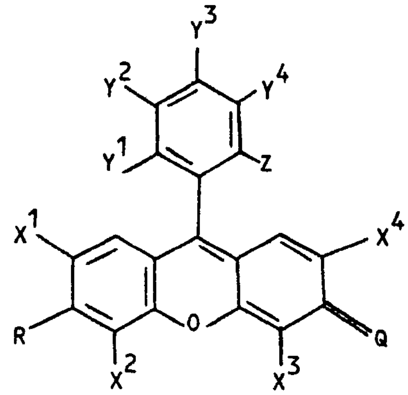

(II)

in which R represents OM, Q represents O, $X^1$, $X^2$, $X^3$ and $X^4$ are individually selected from H, I, Br, $Y^1$, $Y^2$, $Y^3$ and $Y^4$ are individually selected from H, Cl, Br and I and Z is H or COOM, and wherein M (when present) is H, K, Na, Li or $NH_4$ or $C_1$—$C_5$ alkyl; and

c) a reducing agent that will reduce the dye only when in the excited state.

Preferably both alkyl groups $R^1$ and $R^3$ are unsubstituted. Preferably at least one of $R^1$ and $R^3$ is methyl and the preferred compound had $R^1$ and $R^3$ both methyl.

The dye is one that is photoreducible by the reducing agent and thus is reduced by the reducing agent only when it is raised to an excited state by exposure to visible light, preferably, by exposure to sunlight or the light of a tungsten filament lamp. Generally the dye will absorb light at one wavelength and emit it at a shorter wavelength, and is preferably a fluorescing dye. It should absorb in the visible range, i.e. about 400 nm to 800 nm wavelength, and emit in the ultraviolet or shorter wavelength range. Advantageously the absorption in the visible range should be relatively low, in order to prevent the dye rendering the composition opaque. Some absorption may be in the near ultraviolet range. Useful dyes are eosins of formula II

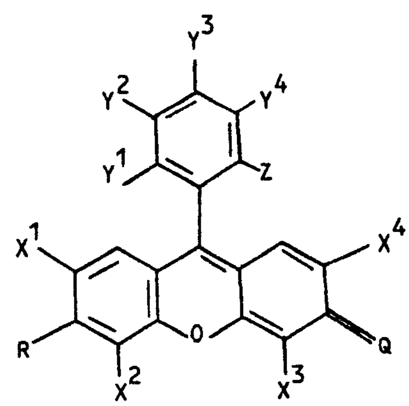

(II)

R represents OM, Q represents O, $X^1$, $X^2$, $X^3$ and $X^4$ are individually selected from H, I and Br, $Y^1$, $Y^2$, $Y^3$ and $Y^4$ are individually selected from H, Cl, Br and I and Z is H or COOM, and wherein M (when present) is H, K, Na, Li or $NH_4$ or $C_1$—$C_5$ alkyl. Preferably at least two of $X^1$, $X^2$, $X^3$ and $X^4$ are I or Br.

Preferred dyes within this group are those in which each of the groups $Y^1$ to $Y^4$ is hydrogen and all the groups $X^1$ to $X^4$ are iodine (for instance erytheosin) or at least two of them are bromine with the others being hydrogen (for instance eosin yellow) as well as such dyes in which each of the groups $X^1$ to $X^4$ is iodine and each of the groups $Y^1$ to $Y^4$ is chlorine (for instance Rose Bengal).

The reducing agent serves to reduce the dye when the dye is in an excited state but should be inert to the dye during storage and when it is not excited by exposure. The reducing agent is generally an amino reducing agent, preferably a compound of formula III

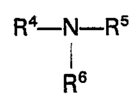

(III)

wherein $R^4$ is optionally substituted alkyl, optionally substituted cycloalkyl, allyl, cycloallyl or optionally

substituted aryl and $R^5$ and $R^6$, which may be the same or different, are selected from the values given for $R^4$ and $R^6$ may form an alkylene chain when $R^5$ is hydrogen, the alkylene chain preferably containing from 2 to 6 methylene groups.

Preferably $R^4$ includes a methylene group adjacent the nitrogen atom and thus may be represented as $R^7CH_2$, where $R^7$ can be any of the groups defined for $R^5$ and $R^6$.

Preferred substituents that may be included in the alkyl, cycloalkyl and aryl groups $R^4$, $R^5$ and $R^6$ include hydroxyl, halo (especially chloro, bromo and fluoro) and amino, and the cycloalkyl and aryl groups may additionally be substituted with, for instance allyl or alkyl. All such alkyl groups are preferably $C_1$–$C_5$ groups or benzyl or other alkyl groups and all aryl groups are preferably phenyl.

One preferred class of amines are benzylamines of the formula $R^7CH_2NR^5R^6$ where $R^7$ is phenyl, $R^5$ is alkyl, hydroxy alkyl, aryl or aralkyl and $R^6$ is hydrogen, alkyl, hydroxy alkyl, aryl or aralkyl, with a preferred compound being tribenzylamine.

Another preferred class of amines are the aliphatic amines in which $R^4$ is an aliphatic group and $R^5$ and $R^6$ are each hydrogen or aliphatic groups, such as mono, di and tributylamines, N,N-dimethyl butylamine, N,N,N,N-tetramethyl ethylenediamine, ethanolamine, allylamine, cyclohexylamine, chloropropylamine, bromopropanolamine, N-fluoroethylallylamine, methylcyclohexylamine, and N,N-allylcyclohexylethanolamine and triethanolamine.

The polymerisable ethylenically unsaturated material may comprise one or more ethylenically unsaturated polymerisable compounds such as styrene, acrylamide, methacrylamide, methylmethacrylate, diethylaminoethyl methacrylate, acrylonitrile and other acrylic polymerisable materials. Blends of polymerisable materials may be used, so as to form copolymers. The material may be wholly monomeric but generally includes some oligomer or polymer and when polymeric material is present in the polymerisable material graft copolymers may be formed between it and polymerisable material that is photopolymerised onto it. The polymerisable material may include compounds having more than one ethylenically unsaturated group, and which will therefore serve as cross-linking agents.

One preferred class of polymerisable ethylenically unsaturated material is unsaturated polyester, which is an unsaturated oligomer or polymer and may be present as a mixture with unsaturated monomer. Generally it is the reaction product of an α,β-unsaturated dibasic acid or anhydride and one or more glycols and optionally a saturated dibasic acid or anhydride, and may be dissolved in a vinyl type monomer.

Preferred unsaturated dibasic acids and anhydrides are maleic anhydride and fumaric acid. Preferred saturated acids are phthalic and isophthalic compounds such as phthalic anhydride, isophthalic acid, terephthalic acid, endomethylenetetrahydrophthalic anhydride, tetrahydrophthalic anhydride, tetrachloro or tetrabromo phthalic anhydride and chlorendic acid but others that may be used include adipic acid and sebasic acid. Preferred glycols are ethyleneglycol, 1,2-propane diol, 1,3-propane diol, diethylene glycol, dipropylene glycol, neopentyl glycol, dibromoeophentyl glycol and glycols made from the reaction of alkylene oxides and bisphenol A. Preferred vinyl monomers are styrene, vinyl toluene and methylmethacrylate but others that may be used include ethylene glycol dimethacrylate, β-hydroxy ethylacrylate and bromostyrene.

Another preferred class of polymeric ethylenically unsaturated material is acrylic material, generally a blend of acrylic monomer and acrylic polymer, most particularly a blend of methylmethacrylate and polymethylmethacrylate.

The amount of the amine or other reducing agent is generally from 0.1 to 5% by weight but amounts up to 10% can be desirable in some instances. Throughout this specification all percentages are, unless otherwise specified, by weight based on the total weight of polymerisable material (including polymer if present), dye, reducing agent and photoinitiator.

The amount of photosensitiser is generally between 0.01 and 1% although amounts up to 2% may sometimes be desirable. Preferred amounts are from 0.5 to 1%.

The amount of dye is generally from 10 ppm to 5000 ppm. Preferably the amount is below 2000 ppm and most preferably it is below 1000 ppm. If it is particularly desirable for the final composition to be colourless the amount of dye is preferably from 10 to 50 ppm or possibly up to 100 ppm but if colour is unimportant higher quantities of dye, typically 200 to 1000 ppm, may be suitable.

If the photosensitive catalyst system is to be provided separate from the polymerisable material then the amounts in the system will generally be 0.1 to 5 parts by weight of the reducing agent, 0.01 to 1 parts by weight of the photosensitiser and 0.001 to 0.5 parts by weight of the dye and this catalyst system is then combined with sufficient of the polymerisable material to bring the total weight up to 100 parts by weight.

It is conventional to include polymerisation inhibitors in polymerisable ethylenically unsaturated materials so as to prevent polymerisation even before combination with whichever catalyst system is to be used. For instance acrylic monomer as received from commercial manufacturers generally includes inhibitor and unsaturated polyesters generally include inhibitor so as to prevent gelling of the components during initial manufacture. The polymerisable material used in forming the compositions of the invention will generally contain appropriate inhibitor, as supplied by the manufacturer, but if it does not already contain inhibitor then it is desirable to add conventional inhibitor. This will prevent polymerisation during the initial blending of the composition and will also improve storage stability. Typical polymerisation inhibitors that may be used include hydroquinones and substituted hydroquinones, benzoquinone and

substituted benzoquinones, various phenols, and paratertiary butyl catechol and other substituted catechols.

The compositions may include ultra-violet stabilisers in order to improve the light stability of the final cured resin, and in particular to prevent its colour increasing as it ages. It is particularly surprising that ultra-violet stabilisers can be included without apparently significantly detracting from the cure that arises from exposure to visible or near ultra-violet light. Suitable ultra-violet stabilisers include benzotriazoles, such as 2-(2-hydroxy-5-methylphenyl)2H-benzotriazole, benzophenones such as 2,4-dihydroxy, 2-hydroxy-4-methoxy or 2,2-dihydroxy-4,4-dimethoxy-benzophenone as well as similar drerivatives, such as the corresponding 5-sulphobenzophenones. Other suitable ultra-violet absorbers include alkyl-2-cyano-3,3-diphenylacrylate wherein the alkyl group may be for instance ethyl or 2-ethylhexyl.

The composition may also include fillers, such as quartz powder, thixotropic agents or other organic or inorganic flow control agents, fire retardants, pigments such as carbon, and reinforcing fibres, e.g. glass fibres. Solvents may be included.

The composition can be blended immediately prior to use but a particular advantage is that the ingredients can be blended to form a composition having good shelf life. The composition is formed by blending the components at a temperature at which the components will go into homogeneous distribution, generally as a solution. The dye and the photosensitiser are generally soluble in the polymerisable material at room temperature and so can be blended at room temperature. Some amino reducing agents and other reducing agents are only soluble at elevated temperatures and so they are generally included by blending with the polymerisable material at an appropriate elevated temperature, for instance 40 to 70°C, the mix is then cooled and the dye and the sensitiser are then blended into the mix. The blending should be conducted in the absence of sufficent radiation to cause curing. The blended composition must be stored under conditions that exclude radiation that would cause curing, and in particular that substantially exclude visible or ultra-violet radiation.

Curing is caused by exposing the composition, in its desired final shape, to appropriate radiation. A particular advantage of the compositions is that they can be fully cured by exposure to a tungsten filament lamp or to sunlight but they can also be fully exposed by exposure to a fluorescent tube. Also polymerisation can be achieved by exposure to ultra-violet light. The intensity of exposure to the north light, sunlight, tungsten light or other light will control the speed of cure.

The compositions of the invention can be used as casting resins, especially when the amino reducing agent is an aliphatic amine and/or when the composition includes an ultra-violet stabiliser and/or when the amount of dye is below 200, and preferably below 100, ppm. It is possible to formulate casting resins that upon curing, will form a highly cured, water clear, product.

The compositions are useful for the production of laminated safety glass.

An important use of the compositions of the invention is as impregnating resins. Thus fibre reinforcement may be impregnated with the uncured composition and shaped into the desired shape before or after impregnation, and the resin is then cured. For instance a composition including reinforcing fibres may be shaped and cured. In another process filaments may be coated with uncured composition and wound or otherwise combined into a shaped product, and the composition then cured. A sheet of glass or other fibres may be impregnated with the composition and then cured, often laminating several such saturated sheets.

The composition may be impregnated into the reinforcement immediately prior to use or, preferably, the composition is provided as a Prepreg product comprising the composition impregnated into a suitable fibre reinforcement and protected by an opaque covering from exposure to light. For example the Prepreg may be provided as a sheet in an opaque package or may be provided as a roll of the impregnated reinforcement laminated with an opaque release sheet from which it may be stripped and that will prevent exposure to light during storage. The fibre reinforcement of Prepregs is generally a woven fibre continuous unidirectional fibre reinforcement or a random chopped fibre sheet.

Compositions that are to be impregnated into fibre reinforcement are generally free of filler or pigment and may either be solvent free or may be present as a solution. It may be necessary to include thickener in the composition so as to provide adequate pick-up and retention by the reinforcement. Suitable thickeners are aluminium compounds such as described in British Patent Specification No. 1578033 and magnesium oxide.

One convenient way of forming an impregnated reinforcement comprises drawing the reinforcement through a solution of the composition, removing excess composition by a doctor blade or metering roller or other means and then heating the product to remove solvent and excess monomer. The product may then be sandwiched between two layers of release film, such as silicone impregnated paper and polyethene or other plastic film, prior to winding or cutting into sheets. In another method a solvent free composition is applied to suitable release films and the fibre reinforcement is sandwiched between two layers of such films.

The compositions of the invention have a number of important advantages. They can be polymerised fully by exposure to convenient light, such as sunlight or tungsten white light or a fluorescent tube. They can be polymerised fully when exposed to air. Thus they are particularly useful as prepregs or other impregnated fibre sheets. They can easily be formulated so as to be very storage stable and so Prepregs or containers holding the bulk composition can have very good shelf life, for instance in excess of 360 days at

ambient temperature. The compositions can be water clear or only very faintly coloured.

It is easily possible to formulate compositions that will adhere very strongly to a wide range of substrates, for instance when applied as prepregs, and so are of great value for repairing damaged pipes, glass, roofing, automobiles and so forth.

The following are some examples of the invention. In each of these examples the photosensitiser was a compound of Formula I wherein $R^2$ and Ph are unsubstituted phenyl and $R^1$ and $R^3$ are both methyl. The particular material that is used is sold under the trade name "Irgacure 651".

All percentages are by weight unless otherwise specified.

Example 1

An unsaturated polyester based on propylene glycol phthalic anhydride, maleic anhydride and containing styrene monomer and inhibitor and fumed silica (sold under the trade name "Polymaster 9T") was blended at about 50°C with 2.5% triethanolamine and then at ambient temperature with 0.02% eosin and 1% photosensitiser. The composition was used to fabricate reinforced laminate containing 3 layers of 450 g/$m^2$ powder brand glass fibre mat at a resin to glass ratio of 2.5:1. The laminate was cured by exposing to dull hazy sunlight for four hours. Gelation occurred after 20 minutes and touch dry time was 30 minutes. After 2 hours Barcol hardness was 42.

Example 2

The process of example 1 was repeated except that exposure was to visible light from tungsten filament lamps with intensity of 6000 lux. The resin gelled in 30 minutes, was touch dry in 45 minutes and fully cured in 2 hours. The Barcol hardness at this stage was 40 to 42.

Example 3

A polyester formed from propylene glycol, phthalic anhydride, maleic anhydride and dissolved in styrene monomer and containing inhibitor (available under the trade name "Polymaster 312-35") was blended with 0.02% eosin and 2% triethanolamine. The blend was clear pink. 0.5% photosensitiser was added and the composition was poured into a glass cell formed by two sheets of plate glass separated by a 6 mm thick U-shaped rubber divider. The cell was exposed to bright sunlight for 2 hours. Gelling occurred after 15 minutes and a strong exotherm was detected after 40 minutes. After the 2 hour exposure the resin was separated from the cell. It was observed that the colour had faded to a straw colour. The heat distortion temperature (HDT) was measured according to British Standard 2782:102G and was found to be 68°C.

When the same resin is cured with methylethylketone peroxide and cobalt naphthenate the HDT is 69°C after post-curing at 70°C for 3 hours.

Example 4

The process of example 1 was repeated using 2% tribenzylamine instead of 2% triethanolamine. The only observed difference was that HDT was 70°C.

Example 5

The process of example 1 was repeated except that exposure was by six 150 Watt tungsten filament spot lamps producing a light intensity of 3600 lux. Gelation occurred in 35 minutes and an exotherm was noted after 80 minutes. After 4 hours the last sheet was removed from the glass cell. The HDT was 68°C.

Example 6

In this example an unsaturated polyester formed from propylene glycol, phthalic anhydride, maleic anhydride, isophthalic acid and dissolved in styrene monomer and containing inhibitor and fumed silica (sold under the trade name Polymaster 2946) was used. A series of compositions were formulated, each containing 1% of the photosensitiser 0.02% eosin and 2% of an amine. Each composition was poured into a tin lid and exposed either to visible light of an intensity of 5000 lux provided by 150 watt lamps or to bright sunlight. The results are given in Tables 1 and 2.

TABLE 1

Visible Light — Tungsten Filament Lamp

| Amine | Gel Time (min) | Touch Dry (mins) | Comments |
|---|---|---|---|
| Tribenzylamine | 20 | 35 | Well cured after 80 minutes |
| Triethanolamine | 21 | 34 | Well cured after 78 minutes |
| Diallylamine | 40 | 65 | Cure time in excess of 2 hours |

TABLE 2

Visible Light — Bright Sunlight

| Amine | Gel Time Minutes | Touch Dry Minutes | Comments |
|---|---|---|---|
| Tribenzylamine | 3 | 8 | Well cured after 45 minutes |
| Triethanolamine | 4 | 10 | Well cured after 45 minutes |
| Diallylamine | 7 | 18 | Cured after 85 minutes |

Example 7

A clear unsaturated polyester that is fire retardant according to BS476 Part VII Class 1 and which is based on maleic and chlorendic acid anhydrides and contains proprietory fire retardant additives and inhibitor and which is available under the trade name "Polymaster 2003" was formulated with 0.6% photosensitiser, 0.02% eosin-spirit soluble and 2.5% triethanolamine. 10 gms of this composition was poured into a shallow aluminium foil mould and irradiated with visible light with an intensity of 15,000 lux. The resin gelled in less than 2 minutes, bleached in four minutes and had an average Barcol hardness of 35 after one hour.

Example 8

An unsaturated polyester resin based on dibromoneopentyl glycol and containing tris-chloroethyl-phosphate as a fire retardant additive was blended with 0.5% photosensitiser, 80 ppm eosin-spirit soluble, 80 ppm eosin Y and 2% tribenzylamine. It was poured into a shallow aluminium foil mould and irradiated with visible light from a tungsten filament bulb. The resin gelled in three minutes, fully bleached in 11 minutes and after 60 minutes had a Barcol hardness of 35 with no surface tack. The exemplified compositions may contain a U.V. stabiliser.

Example 9

A composition was formed by blending 15 parts polymethylmethacrylate, 85 parts methylmethacrylate, 0.02 parts eosin, 2 parts tribenzylamine and 1 part photosensitiser. This composition was used to fabricate a reinforced laminate containing two layers of 450 gm/m$^2$ powder bound glass fibre reinforcement at a ratio of composition:glass of 3:1. The impregnated reinforcement was polymerised by exposure to bright sunlight for two hours, at which time the Barcol hardness was 35. Other satisfactory results can be changed by varying the proportions of methacrylate monomer to polymer in the range 5:95 to 95:5.

Example 10

An unsaturated polyester formed from propylene glycol, phthalic anhydride, maleic anhydride, and isophthalic acid and dissolved in styrene monomer and containing mono-tertiary butyl hydroquinone as inhibitor and containing fumed silica (sold under the trade name "Polymaster 2722") was blended with 0.02% eosin, 2% tribenzylamine and 1% or 0.75% or 0.5% of the acetophenone sensitiser used above or 0.2%, 0.1% or 0.05% of the oxime sensitiser used in European Specification 14293 and sold under the trade name "Quantacure PDO".

In Test A, 100 grams samples of these compositions were stored in tin containers at 20°C and at 50°C. The samples were observed for gelling. The results are given in table 1.

TABLE 1

| Photosensitiser | No. of days @ 20°C | No. of days @ 50°C |
|---|---|---|
| Acetophenone | | |
| 1% | > 360 | > 120 |
| 0.75% | > 360 | > 120 |
| 0.50% | > 360 | > 120 |
| Oxime | | |
| 0.2% | < 80 | 20 |
| 0.1% | < 90 | 28 |
| 0.05% | < 100 | 30 |

It is apparent from this that the compositions of the invention are very much more storage stable than the compositions containing the oxime photosensitiser.

Further samples of the composition were poured into a tin lid and exposed to radiation, while in contact with air. In test B the radiation was provided by 150 watt tungsten filament lamps to an intensity of 5000 lux. The results are shown in Table 2. In test C the radiation was by bright sunlight. The results are shown in Table 3.

TABLE 2

| Photosensitiser | Gel Time Minutes | Time (minutes) for exposed surface to become touch dry | Time for substantially maximum cure |
|---|---|---|---|
| Acetophenone | | | |
| 1.0% | 20 | 35 | 80 mins |
| 0.75% | 25 | 40 | 90 mins |
| 0.5% | 35 | 65 | 2 hours |
| Oxime | | | |
| 0.2% | 10 | 35 mins | 80 mins |
| 0.1% | 15 | 50 mins | 90 mins |
| 0.05% | 20 | 60 mins | 100 mins |

TABLE 3

| Photosensitiser | Gel Time Minutes | Time for exposed surface to become touch dry | Time for substantially maximum cure |
|---|---|---|---|
| Acetophenone | | | |
| 1.0% | 3 | 8—10 | 40 mins |
| 0.75% | 5 | 15 | 50 mins |
| 0.5% | 8 | 30 | 50 mins |
| Oxime | | | |
| 0.2% | 2 | 60 mins | 60 mins |
| 0.1% | 4 | 60 mins | 60 mins |
| 0.05% | 5 | 60 mins | 60 mins |

In both tests B and C, with the acetophenone the exposed surface was tack free when touch dry and at maximum cure but with the oxime it was sticky both when touch dry and at maximum cure.

**Claims**

1. A photocurable composition comprising polymerisable ethylenically unsaturated material and a photosensitive catalyst system for curing the polymerisable material and comprising

a) a photosensitiser

b) a dye that is raised to an excited state by exposure to visible light that is an eosin dye of the formula II

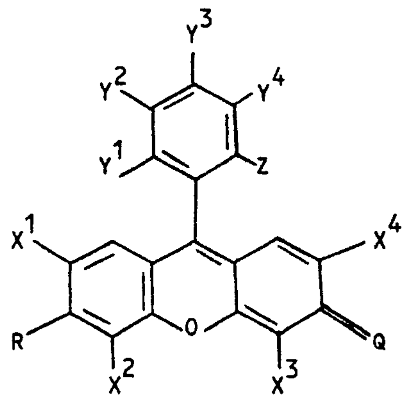

(II)

in which R represents OM, Q represents O, $X^1$, $X^2$, $X^3$ and $X^4$ are individually selected from H, I and Br, $Y^1$, $Y^2$, $Y^3$ and $Y^4$ are individually selected from H, Cl, Br and I and Z is H or COOM, and wherein M (when present) is H, K, Na, Li or $NH_4$ or $C_1$—$C_5$ alkyl, and

c) a reducing agent that will reduce the dye only when in the excited state, characterised in that the photosensitiser is a compound of formula I

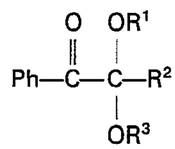

(I)

wherein Ph is an unsubstituted phenyl group, $R^1$ and $R^3$ are each selected from $C_{1-18}$ alkyl groups and $R^2$ is an unsubstituted phenyl group.

2. A composition according to claim 1, in which the dye is a dye that is raised to the excited state, and the composition is curable, by exposure to tungsten filament light or sunlight.

3. A composition according to claim 1, in which the dye is a fluorescent dye that absorbs in or near visible wavelengths and emits in the ultra-violet or shorter wavelengths.

4. A composition according to any preceding claim in which the reducing agent is an amine of formula III

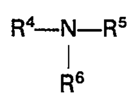

(III)

wherein $R^4$ is optionally substituted alkyl, optionally substituted cycloalkyl, allyl, cycloallyl or optionally substituted aryl and $R^5$ and $R^6$, which may be the same or different, are selected from the values given for $R^4$ and hydrogen, or $R^4$ and $R^6$ may form an alkylene chain when $R^5$ is hydrogen, and in which $R^4$ preferably is the group $R^7CH_2$, wherein $R^7$ can be any of the groups defined for $R^5$ and $R^6$.

5. A composition according to claim 1, in which the reducing agent is selected from benzylamines of the formula $R^7CH_2NR^5R^6$ where $R^7$ is phenyl, $R^5$ is alkyl hydroxy alkyl, aryl or aralkyl and $R^6$ is hydrogen, alkyl, hydroxy, alkyl, aryl or arylkyl, and aliphatic amines of the formula

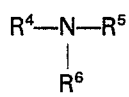

in which $R^4$ is an aliphatic group and $R^5$ and $R^6$ are each selected from hydrogen and aliphatic groups and the dye is selected from eosins of formula II

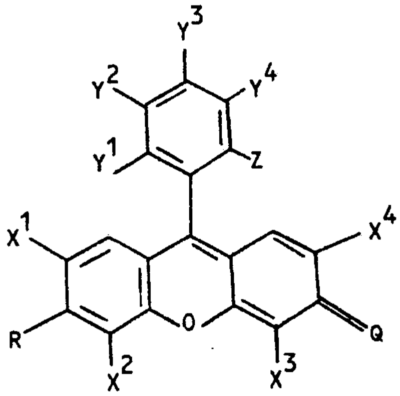

(II)

wherein at least one of the following conditions prevails:—

a) each of the groups $Y^1$ and $Y^4$ is hydrogen and all the groups $X^1$ to $X^4$ are iodine,

b) each of the groups $Y^1$ and $Y^4$ is hydrogen and at least two of the groups $X^1$ to $X^4$ are bromine and the others are hydrogen and

c) each of the groups $X^1$ to $X^4$ is iodine and each of the groups $Y^1$ to $Y^4$ is chlorine.

6. A composition according to claim 1, in which $R^1$ and $R^3$ in the photosensitiser are both methyl and the amine is tribenzylamine.

7. A composition according to claim 1, containing from 0.1 to 5% acetophenone sensitiser, from 0.01 to 2% of the dye and from 0.001 to 0.05% of the reducing agent, all percentages based on the total weight of polymerisable material, acetophenone sensitizer, dye and reducing agent.

8. A composition according to claim 1, in which the polymerisable material is unsaturated polyester.

9. A composition according to claim 1, in which the polymerisable material is unsaturated polyester, the dye can absorb radiation at one wavelength and emit it at another and the reducing agent is an amino reducing agent.

10. A composition according to claim 1, in which the polymerisable material comprises a blend of acrylic monomer and polymer and preferably comprises a blend of methylmethacrylate and polymethylmethacrylate.

11. A method of curing a photocurable composition by exposing it to light, characterised in that the light is sunlight, tungsten filament light or fluorescent tube light and the composition is a composition according to any of claims 1 to 10.

12. A prepreg comprising a fibre reinforcement impregnated with a photocurable composition characterised in that the composition is a composition according to any of claims 1 to 10.

**Patentansprüche**

1. Photohärtbare Zusammensetzung mit einem polymerisierbaren ethylenisch ungesättigten Material und einem photoempfindlichen Katalysatorsystem zum Aushärten des polymerisierbaren Materials, das umfaßt

a) einen Photosensibilisator

b) einen Farbstoff, der durch Belichtung mit sichtbarem Licht in einen angeregten Zustand gebracht wird, d.h. einen Eosinfarbstoff der Formel II

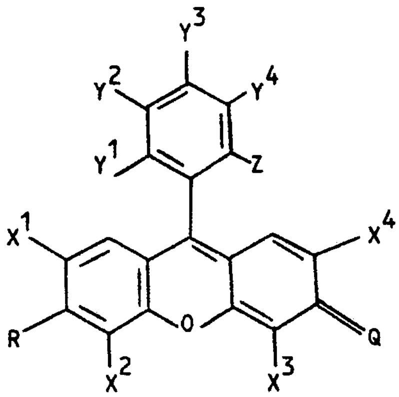

(II)

in welchem R=Om darstellt, Q=O bedeutet, $X^1$, $X^2$, $X^3$ und $X^4$ jeweils ausgewählt sich von H, J und Br; $Y^1$, $Y^2$, $Y^3$ und $Y^4$ jeweils ausgewählt sind von H, Cl, Br und J, und Z für H oder COOM steht, worin M (falls anwesend) für H, K, Na, Li oder $NH_4$ oder $C_1$—$C_5$ Alkyl steht, und

c) ein Reduktionsmittel, das den Farbstoff nur im angeregten Zustand reduziert, dadurch gekennzeichnet, daß der Photosensibilisator eine Verbindung der Formel I ist

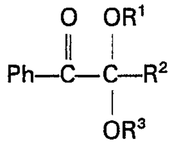

(I)

worin Ph eine unsubstituierte Phenylgruppe ist, $R^1$ und $R^3$ jeweils ausgewählt sind von $C_{1-18}$-Alkylgruppen und $R^2$ für eine unsubstituierte Phenylgruppe steht.

2. Zusammensetzung nach Anspruch 1, in welcher der Farbstoff ein solcher ist, der in den angeregten Zustand gebracht wird, und die Zusammensetzung durch Belichtung mit Licht von einem Wolframfaden oder Sonnenlicht aushärtbar ist.

3. Zusammensetzung nach Anspruch 1, in welcher der Farbstoff ein fluoreszierender Farbstoff ist, der in oder nahe bei sichtbaren Wellenlängen absorbiert und in UV- oder kürzeren Wellenbereichen emittiert.

4. Zusammensetzung nach irgendeinem vorhergehenden Anspruch, in welcher das Reduktionsmittel ein Amin der Formel III

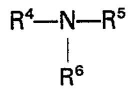

(III)

ist, worin $R^4$ für gegebenenfalls substituiertes Alkyl, gegebenenfalls substituiertes Cycloalkyl, Allyl, Cycloallyl oder gegebenenfalls substituiertes Aryl steht und $R^5$ und $R^6$, die gleich oder verschieden sein können, ausgewählt sind aus den für $R^4$ angegebenen Bedeutungen und Wasserstoff, oder $R^4$ und $R^6$ könnon eine Alkylenkette bilden, wenn $R^5$ Wasserstoff ist, und worin $R^4$ vorzugsweise die Gruppe $R^7CH_2$ ist, wobei $R^7$ irgendeine der für $R^5$ und $R^6$ definierten Gruppen sein kann.

5. Zusammensetzung nach Anspruch 1, in welcher das Reduktionsmittel ausgewählt ist aus Benzylaminen der Formel $R^7CH_2NR^5R^6$, worin $R^7$ Phenyl bedeutet, $R^5$ für Alkyl, Hydroxyalkyl, Aryl oder Aralkyl steht, und $R^6$ Wasserstoff, Alkyl, Hydroxyalkyl, Aryl oder Aralkyl bedeutet, und aliphatischen Aminen der Formel

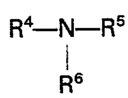

in welcher $R^4$ eine aliphatische Gruppe ist, und $R^5$ und $R^6$ jeweils ausgewählt sind von Wasserstoff und aliphatischen Gruppen, und der Farbstoff ausgewählt ist von Eosinen der Formel II

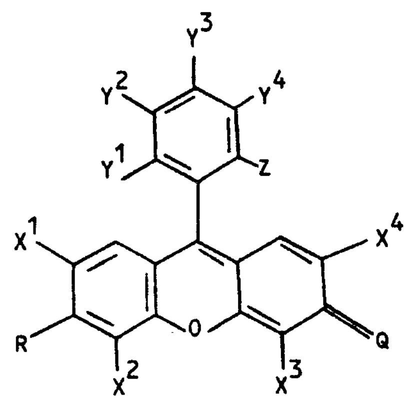

(II)

worin mindestens eine der folgenden Bedingungen vorherrscht:

a) jede der Gruppen $Y^1$ und $Y^4$ ist Wasserstoff und alle Gruppen $X^1$ bis $X^4$ bedeuten Jod,

b) jede der Gruppen $Y^1$ und $Y^4$ ist Wasserstoff und mindestens 2 der Gruppen $X^1$ bis $X^4$ bedeuten Brom und die anderen Wasserstoff, und

c) jede der Gruppen $X^1$ bis $X^4$ bedeutet Jod und jede der Gruppen $Y^1$ bis $Y^4$ bedeutet Chlor.

6. Zusammensetzung nach Anspruch 1, in welcher $R^1$ und $R^3$ im Photosensibilisator jeweils Methyl bedeuten und das Amin Tribenzylamin ist.

7. Zusammensetzung nach Anspruch 1, enthaltend 0,1 bis 5% Acetophenonsensibilisator, 0,01 bis 2% des Farbstoffes und 0,001 bis 0,05% des Reduktionsmittels, wobei alle Prozentsätze bezogen sind auf das Gesamtgewicht aus polymerisierbarem Material, Acetophenonsensibilisator, Farbstoff und Reduktionsmittel.

8. Zusammensetzung nach Anspruch 1, in welcher das polymerisierbare Material ein ungesättigter Polyester ist.

9. Zusammensetzung nach Anspruch 1, in welcher das polymerisierbare Material ein ungesättigter Polyester ist, der Farbstoff Strahlung bei einer Wellenlänge absorbieren und bei einer anderen emittieren kann und das Reduktionsmittel ein Amino-Reduktionsmittel ist.

10. Zusammensetzung nach Anspruch 1, in welcher das polymerisierbare Material eine Mischung aus Acryl-Monomer und Polymer umfaßt und vorzugsweise eine Mischung aus Methylmethacrylat und Polymethylmethacrylat umfaßt.

11. Verfahren zum Aushärten einer photohärtbaren Zusammensetzung durch Belichtung mit Licht, dadurch gekennzeichnet, daß das Licht Sonnenlicht, Licht von einem Wolframfaden oder einer Fluoreszenzröhre ist und die Zusammensetzung eine solche gemäß irgendeinem der Ansprüche 1 bis 10 ist.

12. Prepreg mit einer Faserverstärkung, die mit einer photohärtbaren Zusammensetzung imprägniert ist, dadurch gekennzeichnet, daß die Zusammensetzung eine solche gemäß einem der Ansprüche 1 bis 10 ist.

**Revendications**

1. Une composition photodurcissable comprenant une substance éthyénique polymérisable et un système catalytique photosensible pour durcir la substance polymérisable et comprenant

a) un photosensibilisateur

b) un colorant d'éosine, qui est excité par exposition à la lumière visible, de formule

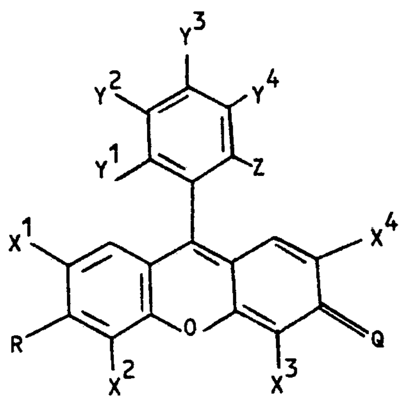

(II)

dans laquelle R représente OM, Q représente O, $X^1$, $X^2$, $X^3$ et $X^4$ sont choisis individuellement parmi H, I et Br, $Y^1$, $Y^2$, $Y^3$ et $Y^4$ sont choisis individuellement parmi H, Cl, Br et I et Z est H ou COOM, et M, le cas échéant, est H, K, Na, Li ou $NH_4$ ou bien alkyle en $C_1$—$C_5$ et

c) un agent réducteur qui ne réduit le colorant que lorsqu'il est à l'état excité, caractérisée en ce que le photosensibilisateur est un composé de formule I

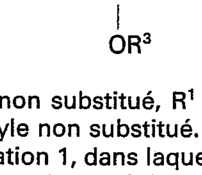

(I)

dans laquelle Ph est un groupe phényle non substitué, $R^1$ et $R^3$ sont choisis chacun parmi les groupes alkyles en $C_{1-18}$ et $R^2$ est un groupe phényle non substitué.

2. Une composition selon la revendication 1, dans laquelle le colorant est excité et la composition est durcissable par exposition à la lumière d'une lampe à filament de tungstène ou à la lumière solaire.

3. Une composition selon la revendication 1, dans laquelle le colorant est un colorant fluorescent qui absorbe aux longueurs d'onde visibles ou voisines du visible et émet aux longueurs d'onde de l'ultraviolet ou plus courtes.

4. Une composition selon l'une quelconque des revendications précédentes, dans laquelle l'agent réducteur est une amine de formule

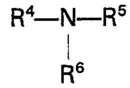

(III)

dans laquelle $R^4$ est un groupe alkyle facultativement substitué, cycloalkyle facultativement substitué, allyle, cycloallyle ou aryle facultativement substitué et $R^5$ et $R^6$, qui peuvent être identiques ou différents, sont choisis parmi les restes représentés par $R^4$ et l'hydrogène, ou bien $R^4$ et $R^6$ peuvent former une chaîne alkylène lorsque $R^5$ est l'hydrogène, et dans laquelle $R^4$ est de préférence le groupe $R^7CH_2$, dans lequel $R^7$ peut être l'un quelconque des groupes définis pour $R^5$ et $R^6$.

5. Une composition selon la revendication 1, dans laquelle l'agent réducteur est choisi parmi les benzylamines de formule $R^7CH_2NR^5R^6$ dans laquelle $R^7$ est un groupe phényle, $R^5$ est un groupe alkyle, hydroxyalkyle, aryle ou arylalkyle et $R^6$ est l'hydrogène ou un groupe alkyle, hydroxyalkyle, aryle ou arylalkyle et les amines aliphatiques de formule

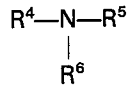

dans laquelle $R^4$ est un groupe aliphatique et $R^5$ et $R^6$ sont choisis chacun parmi l'hydrogène et les groupes aliphatiques et le colorant est choisi parmi les éosines de formule II

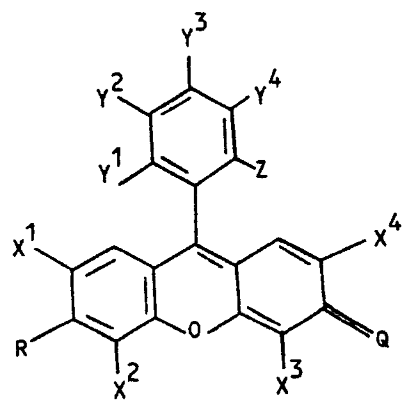

(II)

avec l'une au moins des conditions suivantes:

a) chacun des groupes $Y^1$ et $Y^4$ est l'hydrogène et tous les groupes $X^1$ à $X^4$ sont de l'iode,

b) chacun des groupes $Y^1$ et $Y^4$ est l'hydrogène et au moins deux des groupes $X^1$ à $X^4$ sont du brome et les autres sont de l'hydrogène, et

c) chacun des groupes $X^1$ à $X^4$ est l'iode et chacun des groupes $Y^1$ à $Y^4$ est le chlore.

6. Une composition selon la revendication 1, dans laquelle $R^1$ et $R^3$ dans le photosensibilisateur sont tous deux méthyle et l'amine est la tribenzylamine.

7. Une composition selon la revendication 1, contenant de 0,1 à 5% d'un sensibilisateur du type acétophénone, de 0,01 à 2% du colorant et de 0,001 à 0,05% de l'agent réducteur, tous les pourcentages étant rapportés au poids total de substance polymérisable, sensibilisateur du type acétophénone, colorant et agent réducteur.

8. Une composition selon la revendication 1, dans laquelle la substance polymérisable est un polyester insaturé.

9. Une composition selon la revendication 1, dans laquelle la substance polymérisable est un polyester insaturé, le colorant peut absorber la radiation à une longueur d'onde et l'émettre à une autre et l'agent réducteur est un agent réducteur du type amino.

10. Une composition selon la revendication 1, dans laquelle la substance polymérisable consiste en un mélange de monomère et de polymère acryliques et de préférence un mélange de méthacrylate de méthyle et de polyméthacrylate de méthyle.

11. Un procédé pour durcir une composition photodurcissable par exposition à la lumière, caractérisé en ce que la lumière est la lumière solaire, la lumière d'une lampe à filament de tungstène ou la lumière d'un tube fluorescent et la composition est une composition selon l'une quelconque des revendications 1 à 10.

12. Un préimprégné comprenant des fibres de renforcement imprégnées par une composition photodurcissable, caractérisé en ce que la composition est une composition selon l'une quelconque des revendications 1 à 10.